# EUROPEAN PATENT APPLICATION

(11) **EP 4 478 067 A1**
(43) Date of publication of application: **18.12.2024**
(21) Application number: 24179276.1
(22) Date of filing: 31.05.2024
(51) Int. Cl.: G01R 31/382, G01R 31/396, H01M 10/48, H02J 7/00

(54) **MANAGEMENT METHOD AND MANAGEMENT SYSTEM OF SECONDARY BATTERY**

(30) Priority: 02.06.2023 CN 202310652066
(71) Applicant: REPT BATTERO Energy Co., Ltd., Wenzhou Zhejiang (CN); Shanghai Ruipu Energy Co., Ltd., Shanghai 201206 (CN)
(72) Inventor: SHEN, Xiangdong, Pudong New District (CN); HOU, Min, Pudong New District (CN); SHEN, Chengyu, Pudong New District (CN); CAO, Hui, Wenzhou (CN)
(74) Representative: Potter Clarkson

(57) **Abstract**

The present disclosure provides a management method and a management system of a secondary battery, the secondary battery comprises N battery cells connected in series, N being a positive integer greater than or equal to 2. The management method comprises: acquiring a voltage and a battery capacity parameter of both ends of the secondary battery in real time during at least one process of a charging process and a discharging process; determining a characteristic point of the voltage during its changing process, comprising: calculating a ratio of a change of the voltage relative to a change of the battery capacity parameter in real time when the voltage reaches a preset range, and determining that one characteristic point occurs during the changing process of the voltage when the ratio is greater than a characteristic threshold; and determining a uniformity of the secondary battery based on a number of the characteristic points. The management method and the management system of the present disclosure reduce the number of sampling lines, do not rely on the use of AFE chip, have strong practicality, and reduce the cost of the product.

## Description

### FIELD OF THE DISCLOSURE

The present disclosure mainly relates to the field of secondary battery, and in particular relates to a management method and a management system of a secondary battery.

### BACKGROUND

Secondary battery usually consists of one string or multiple strings of cells connected in series, parallel or series-parallel. Since secondary battery is made of highly active materials with high energy density, the battery needs to be monitored during its charging and discharging processes to prevent over-charging and over-discharging. However, due to the different self-discharge rates of multiple cells, the SOC (State of Charge) of each cell is inconsistent, so it is necessary to determine the balanced state of the secondary battery, and if it is not balanced, it is necessary to take measures to control all the cells to maintain a basically consistent SOC. The current solution is to use AFE (Analog Front End) chip for battery sampling, determination of the uniformity and balancing, however, AFE is basically monopolized by foreign chip companies, the price is high, at the same time, each battery cell needs to be connected to the AFE through wiring harness, the wiring harness connection is complex and prone to short circuits, and more costs need to be invested in safety design, which will further increase the cost.

### SUMMARY

The technical problem to be solved by the present disclosure is to provide a management method and management system of secondary battery that facilitates detection of uniformity, effectively prevents over-charging and over-discharging, and has low cost.

To solve the above technical problem, the present disclosure provides a management method of a secondary battery, wherein the secondary battery comprises N battery cells connected in series, and N is a positive integer greater than or equal to 2, the method comprising: acquiring a voltage and a battery capacity parameter of both ends of the secondary battery in real time during at least one process of a charging process and a discharging process; determining a characteristic point of the voltage during its changing process, comprising: calculating a ratio of a change of the voltage relative to a change of the battery capacity parameter in real time when the voltage reaches a preset range, and determining that one characteristic point occurs during the changing process of the voltage when the ratio is greater than a characteristic threshold; and determining uniformity of the secondary battery based on a number of the characteristic points.

In an embodiment of the present disclosure, during the charging process, a step of acquiring the voltage and the battery capacity parameter of both ends of the secondary battery in real time comprises: acquiring a charging voltage and a battery capacity parameter of charging of both ends of the secondary battery in real time; a step of determining the characteristic point of the voltage during its changing process comprises: calculating a first ratio of a change of the charging voltage relative to a change of the battery capacity parameter of charging in real time when the charging voltage exceeds a total initial charging threshold, and determining that a charging characteristic point occurs during the charging process when the first ratio is greater than a first threshold; a step of determining the uniformity of the secondary battery based on the number of the characteristic points comprises: acquiring a charging characteristic point number of the charging characteristic point when the charging voltage is greater than or equal to a total charging cut-off voltage, and determining that the uniformity of the secondary battery is good if the charging characteristic point number is equal to N.

In an embodiment of the present disclosure, the total charging cut-off voltage is equal to N times of an upper limit of charging voltage of the battery cell.

In an embodiment of the present disclosure, further comprising: setting a first upper limit for the first ratio, and determining that at least two mutually overlapping charging characteristic points occur during the charging process when the first ratio exceeds the first upper limit, counting an actual number of the overlapping charging characteristic points into the charging characteristic point number.

In an embodiment of the present disclosure, the step of determining the uniformity of the secondary battery based on the number of the characteristic points further comprises: determining that the uniformity of the secondary battery is poor if the charging characteristic point number is less than N; setting a charging mode to a balanced charging mode when determining that the uniformity of the secondary battery is poor, and in the balanced charging mode, continuing to charge a first preset capacity and then stopping the charging process when the charging characteristic point number is equal to N.

In an embodiment of the present disclosure, the balanced charging mode comprises: charging with a constant voltage, the constant voltage being in a range between the total charging cut-off voltage and a total clamping voltage, the total clamping voltage being equal to N times of a clamping voltage of shuttle agent of the battery cell.

In an embodiment of the present disclosure, the balanced charging mode comprises: charging with a constant current, the constant current being less than or equal to an allowable current of shuttle agent of the battery cell.

In an embodiment of the present disclosure, the first preset capacity is equal to the increased battery capacity required to charge the voltage of the battery cell from the upper limit of charging voltage of the battery cell to the clamping voltage of shuttle agent of the battery cell.

In an embodiment of the present disclosure, the balanced charging mode comprises: recording a time interval between adjacent charging characteristic points, and acquiring a capacity difference of different battery cells according to the time interval.

In an embodiment of the present disclosure, during the discharging process, a step of acquiring the voltage and the battery capacity parameter of both ends of the secondary battery in real time comprises: acquiring a discharging voltage and a battery capacity parameter of discharging of both ends of the secondary battery in real time; a step of determining the characteristic point of the voltage during the changing process comprises: calculating a second ratio of a change of the discharging voltage relative to a change of the battery capacity parameter of discharging in real time when the discharging voltage is less than a total initial discharging threshold, and determining that a discharging characteristic point occurs during the discharging process when the second ratio is greater than a second threshold; a step of determining the uniformity of the secondary battery based on the number of the characteristic points comprises: acquiring a discharging characteristic point number of the discharging characteristic point when the discharge of the secondary battery is finished, and determining that the uniformity of the secondary battery is good if the discharging characteristic point number is equal to N.

In an embodiment of the present disclosure, when the discharging voltage is less than or equal to a total discharge cut-off voltage, the discharge of the secondary battery is finished.

In an embodiment of the present disclosure, further comprising: before the discharging voltage reaches the total discharge cut-off voltage, and when the discharging voltage is less than a total discharge threshold, and when the discharging characteristic point number increases by 1, and after continuing to release a second preset capacity, the discharge of the secondary battery is finished, wherein the total discharge threshold is less than the total initial discharging threshold, and the total discharge threshold is greater than the total discharge cut-off voltage.

In an embodiment of the present disclosure, further comprising: setting a second upper limit for the second ratio, and determining that at least two mutually overlapping discharging characteristic points occur during the discharging process when the second ratio exceeds the second upper limit, counting an actual number of the overlapping discharging characteristic points into the discharging characteristic point number.

In an embodiment of the present disclosure, the step of determining the uniformity of the secondary battery based on the number of the characteristic points further comprises: determining that the uniformity of the secondary battery is poor if the discharging characteristic point number is less than N; setting a charging mode for a next charging process to a balanced charging mode when determining that the uniformity of the secondary battery is poor.

In an embodiment of the present disclosure, the battery cell comprises one or a combination of any of lithium battery, sodium battery and potassium battery.

In an embodiment of the present disclosure, the battery capacity parameter comprises a combination of any one or more of a current battery capacity, a state of charge, and a battery usage duration.

In order to solve the above technical problem, the present disclosure also proposes a management system of a secondary battery, the secondary battery comprising N battery cells connected in series, N being a positive integer greater than or equal to 2, wherein it comprises a controller and at least one sampling circuit, the at least one sampling circuit being connected to both ends of the secondary battery for capturing a voltage of the secondary battery and sending the voltage to the controller, the controller being configured to: performing the management method as described above.

The management method of the secondary battery of the present disclosure can determine the uniformity of the secondary battery during the charging process and/or the discharging process, and then control the charging process and the discharging process of the battery, and can effectively prevent over-charging and over-discharging. The management system of the secondary battery of the present disclosure reduces the number of sampling lines, has strong practicality, does not rely on the use of AFE chip, can reduce the number of AFE channels, and even does not need to use AFE chip, and significantly reduces the cost of the product.

### BRIEF DESCRIPTION OF THE DRAWINGS

The accompanying drawings are included to provide a further understanding of the present disclosure, they are included and form part of the present disclosure, the accompanying drawings illustrate embodiments of the present disclosure and together with the specification serve to explain the principles of the disclosure. In the accompanying drawings:
FIG. 1A is a block diagram of a management system of a secondary battery of an embodiment of the present disclosure;
FIG. 1B is a block diagram of a management system of a secondary battery of another embodiment of the present disclosure;
FIG. 2 is an exemplary flowchart of a management method of a secondary battery of an embodiment of the present disclosure;
FIG. 3 is a schematic diagram of a charging curve of a battery cell in a secondary battery of an embodiment of the present disclosure;
FIG. 4 is a schematic diagram of a discharging curve of a battery cell in a secondary battery of an embodiment of the present disclosure.

### PREFERRED EMBODIMENTS OF THE PRESENT DISCLOSURE

In order to more clearly illustrate the technical solutions of the embodiments of the present disclosure, the accompanying drawings to be used in the description of the embodiments will be briefly described below. Obviously, the accompanying drawings in the following description are only some examples or embodiments of the present disclosure, and it is possible for a person of ordinary skill in the art to apply the present disclosure to other similar scenarios based on the accompanying drawings without creative effort. The same symbols in the drawings represent the same structure or operation unless it is obvious from the language or otherwise indicated.

As indicated in the present disclosure and the claims, unless the context clearly suggests an exception, the words "one", "a", "a kind of', and/or "the" do not refer specifically to the singular but may also include the plural. In general, the terms "including" and "comprising" suggest only the inclusion of clearly identified steps and elements, the steps and elements do not constitute an exclusive list, and other steps or elements may be included in the method or apparatus.

Unless otherwise specified, the relative arrangement, numerical expressions, and numerical values of the components and steps described in the embodiments do not limit the scope of the present disclosure. At the same time, it should be understood that the dimensions of the various parts shown in the accompanying drawings are not drawn in actual proportional relationship for ease of description. Techniques, methods and apparatus known to one of ordinary skill in the relevant field may not be discussed in detail, but where appropriate, the techniques, methods and apparatus should be regarded as part of the authorized specification. In all of the examples illustrated and discussed herein, any specific values should be interpreted as merely exemplary and not as limitations. Thus, other examples of exemplary embodiments may have different values. It should be noted that: similar symbols and letters denote similar items in the following accompanying drawings, and therefore, once an item is defined in an accompanying drawing, no further discussion of it is required in the subsequent accompanying drawings.

In addition, it should be noted that the use of terms such as "first" and "second" to qualify the parts and components is only for the purpose of facilitating the differentiation of the corresponding parts and components, and the terms do not have special meanings if not otherwise declared, and therefore cannot be construed as a limitation of the scope of protection of the present disclosure. In addition, although the terms used in the present disclosure are selected from the publicly known common terms, some of the terms mentioned in the specification of the present disclosure may have been selected by the applicant according to his or her determination, and their detailed meanings are described in the relevant parts of the description herein. In addition, it is required that the present disclosure be understood not only by the actual terms used, but also by the meaning implied by each term.

Flowcharts are used in the present disclosure to illustrate the operations performed by a system according to embodiments of the present disclosure. It should be understood that the preceding or following operations are not necessarily performed in an exact sequence. Instead, various steps may be processed in reverse order or simultaneously. At the same time, other operations may be added to these processes or a step or steps may be removed from these processes.

The management method and management system of the secondary battery of the present disclosure are applicable to all types of lithium batteries, sodium batteries, potassium batteries and so on. Especially for secondary batteries with the risk of over-charging or over-discharging. Lithium batteries include lithium-ion batteries and lithium-metal batteries, and taking lithium-ion batteries as an example, the battery cell thereof can be set with a clamping voltage by adding a shuttle agent (shuttle). The battery cells of lithium-ion batteries include but are not limited to lithium iron phosphate batteries and ternary lithium-ion batteries. Lithium-metal batteries include but are not limited to lithium sulfur batteries, lithium air batteries, and so on. Sodium batteries include sodium-ion batteries, sodium-metal batteries, and so on. Potassium batteries include potassium-ion batteries, potassium-metal batteries, and so on.

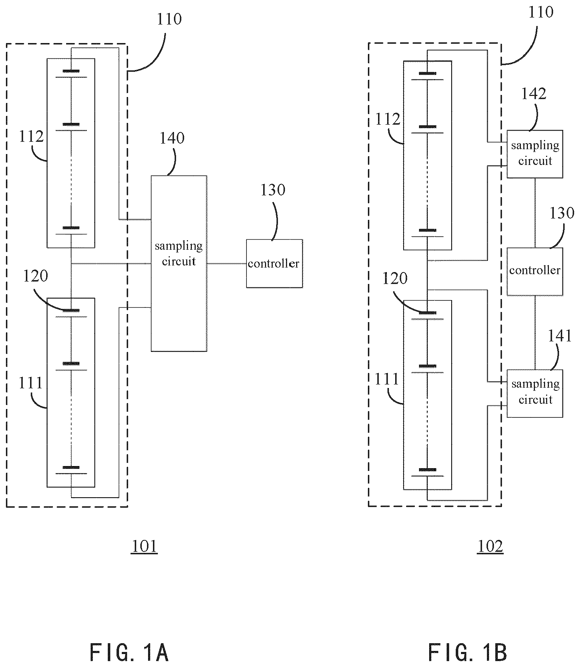

FIG. 1A is a block diagram of a management system of a secondary battery of an embodiment of the present disclosure. The secondary battery of the present disclosure comprises N battery cells connected in series, N being a positive integer greater than or equal to 2, and the N battery cells form two battery packs 111, 112. The battery cell is also referred to as cell, and the specific battery cell has different charging and discharging characteristics depending on the model and manufacturer. It should be noted that the number of battery cells 120 in different battery packs may be equal or unequal.

The management system of the present disclosure further comprises a controller and at least one sampling circuit, the at least one sampling circuit being connected to both ends of the secondary battery for collecting voltage and battery capacity parameter of the secondary battery. As shown in FIG. 1A, the management system 101 of the embodiment includes one controller 130 and one sampling circuit 140. The sampling circuit 140 is connected to one end of the battery pack 111 and the other end of the battery pack 112 respectively, which are connected to the two ends of the secondary battery 110, namely the main positive electrode and the main negative electrode with only two sampling lines required. The sampling circuit 140 is also electrically connected to the controller 130 for sending the collected voltage of the secondary battery 110 to the controller 130.

FIG. 1B is a block diagram of a management system of a secondary battery of another embodiment of the present disclosure. The management system 102 of the embodiment includes two sampling circuits 141, 142, the sampling circuits and the battery packs correspond one to one. Wherein the sampling circuit 141 is connected to both ends of the battery pack 111 and is capable of sending the voltage of both ends of the battery pack 111 to the controller 130, and the sampling circuit 142 is connected to both ends of the battery pack 112 and is capable of sending the voltage of both ends of the battery pack 112 to the controller 130, which is equivalent to sending the voltage of both ends of the secondary battery 110 to the controller 130. In some embodiments, the controller 130 is an MCU.

The battery capacity parameter collected in the present disclosure refers to any parameter that can be used to characterize the battery capacity, for example, including one of a current battery capacity or a state of charge SOC. The SOC represents a ratio of the remaining capacity of the battery to its total capacity in the fully charged state, and the product of the SOC and the total capacity is the current battery capacity, that is the remaining capacity of the battery, and the two can be treated equivalently. In an embodiment, the battery capacity has a certain trend of change with the battery usage duration, so the battery usage duration can also be used as a battery capacity parameter for considering the battery capacity. Wherein, during the charging process, the battery usage duration may refer to the battery charging duration, and during the discharging process, the battery usage duration may refer to the battery discharging duration.

According to the management system 101 of the present disclosure, the voltage of the secondary battery 110 can be acquired by the sampling circuit 140, and the controller 130 can acquire the voltage and the battery capacity parameter of the secondary battery 110 of both ends of the secondary battery during at least one process of the charging process and the discharging process, and execute the management method of the present disclosure to determine the uniformity of the secondary battery, so that the risk of over-charging or over-discharging of the secondary battery 110 can be further prevented. Compared with the solution using AFE chip, the management system has the advantages of simple structure and small number of sampling lines, which can reduce the number of AFE channels, that is, reduce the number of expensive AFE chips, and even do not need to use AFE chips, thus greatly reduce the cost of the product.

For the management system 102, the sampling circuits 141, 142 are connected to the controller 130 respectively, so as to determine the uniformity of the plurality of battery cells in the battery packs 111, 112 respectively. It is also possible for the controller 130 to acquire all signals from the sampling circuits 141, 142 to determine the uniformity of the plurality of battery cells in the two battery packs 111, 112 of the entire secondary battery 110.

It should be noted that the management system of the present disclosure may be used to perform the management method disclosed herein, however, the management method of the present disclosure may also be performed by other management systems. The specification illustrates the management method of the present disclosure in conjunction with the management system 101 shown in FIG. 1A, and is not intended to limit the specific subject matter of execution of the management method.

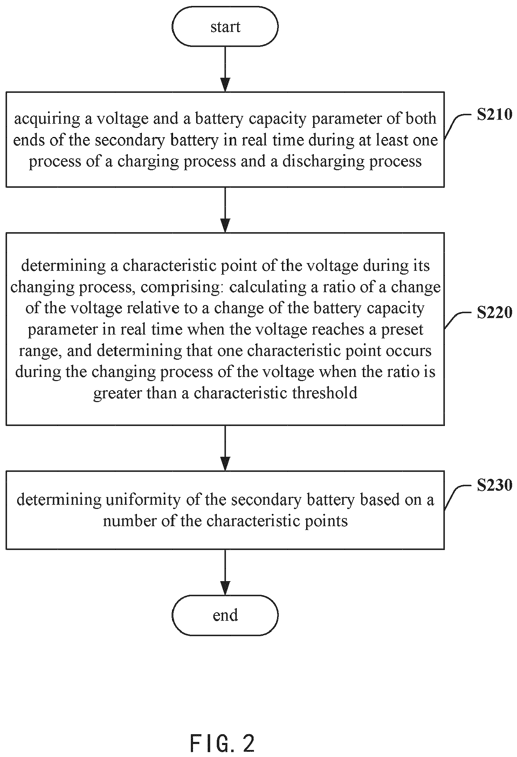

FIG. 2 is an exemplary flowchart of a management method of a secondary battery of an embodiment of the present disclosure. Referring to FIG. 2, the management method of the embodiment includes the following steps:
Step S210: during at least one process of the charging process and the discharging process, acquiring a voltage and a battery capacity parameter of both ends of the secondary battery in real time;
Step S220: determining a characteristic point of the voltage during its changing process, comprising: when the voltage reaches a preset range, calculating a ratio of a change of the voltage relative to a change of the battery capacity parameter in real time, and when the ratio is greater than a characteristic threshold, determining that one characteristic point occurs during the changing process of the voltage;
Step S230: determining uniformity of the secondary battery based on a number of the characteristic points.

According to step S210, the method is suitable to be applied only during the charging process, only during the discharging process, and in both of the charging process and the discharging process. The following are described separately according to the two processes, the charging process and the discharging process.

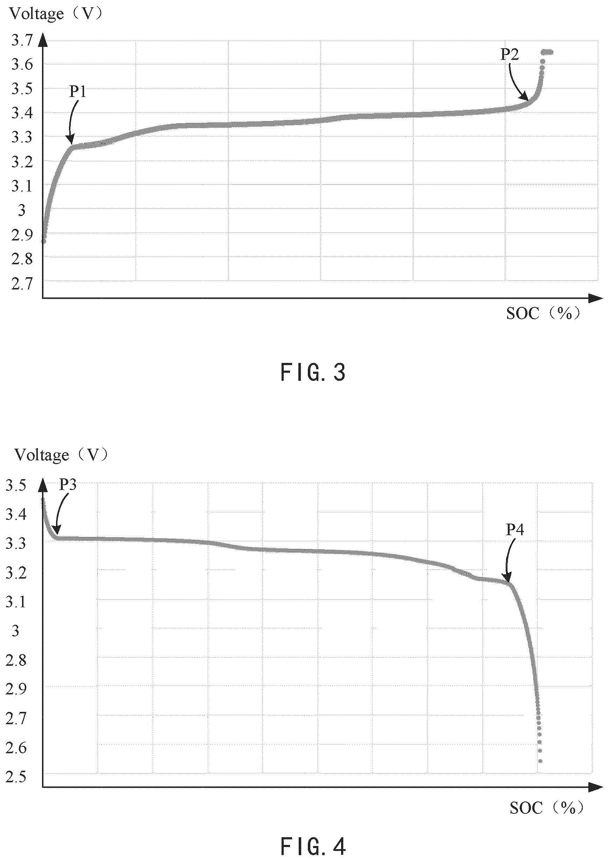

FIG. 3 is a schematic diagram of a charging curve of a battery cell in a secondary battery of an embodiment of the present disclosure. Referring to FIG. 3, it is shown that the horizontal axis is the SOC in %, and the vertical axis is the voltage in V (Volt). In FIG. 3, from the origin, the SOC gradually increases from left to right along the horizontal axis, and the voltage gradually increases from bottom to top along the vertical axis. It should be noted that the relationship between the current battery capacity and the voltage is similar to the relationship between the SOC and the voltage, and the trend of its corresponding charging curve is the same, therefore, in some embodiments, the horizontal axis may also be the current battery capacity. Moreover, the change trend of the voltage with the battery usage duration is also similar to its change trend with the SOC, thus, in some embodiments, the horizontal axis may be the battery usage duration, that is the battery charging duration.

In some embodiments, the characteristic point can also be determined by considering the voltage in combination with the current battery capacity, the SOC, and the battery usage duration, for example, by the relationship between the voltage and any two or three of the current battery capacity, the SOC, and the battery usage duration respectively, the acquired characteristic points are verified, and so on. Technicians in the field can make any kind of changes based on the actual situation, all of which fall within the scope of protection of the present disclosure.

As shown in FIG. 3, at the initial time, the voltage of the battery cell is low, located between 2.8-2.9 V, and needs to be charged. The slope of the charging curve has the characteristics of being large on both sides and small in the middle. In the initial stage, the slope of the charging curve is larger, and the voltage reaches a higher voltage value at a faster speed, such as at the inflection point P1 in FIG. 3, after which the slope of the charging curve becomes smaller and the speed of voltage increase slows down, until after reaching the inflection point P2, the slope of the charging curve increases again and the speed of voltage increase increases again. In FIG. 3, the inflection point P1 corresponds to a smaller SOC with the voltage between 3.2-3.3V, and the inflection point P2 corresponds to a larger SOC with the voltage between 3.4-3.5V. FIG. 3 is used to represent the charging pattern of the battery cell, and for the secondary battery 110 including the N battery cells 120 shown in FIG. 1A, since the N battery cells 120 are connected in series, the charging curve of the entire secondary battery 110 has a similar trend. However, since there are inconsistencies in the SOC of each battery cell, the charging curve of the entire secondary battery 110 does not correspond to a simple superposition of the charging curves of the N battery cells, but is subject to fluctuations, thereby forming a plurality of inflection points in the total charging curve.

FIG. 3 is shown for illustrative purposes only and is not intended to limit the actual charging curve and voltage values of the battery cell 120. Steps S210-S230 of embodiment 1 are described below with reference to FIG. 1A and FIG. 3.

In the embodiment 1, in step S210, during the charging process, acquiring the voltage and the battery capacity parameter of both ends of the secondary battery in real time.

In some embodiments, the step S210 comprises:
Step S211: acquiring a charging voltage and a battery capacity parameter of charging of both ends of the secondary battery in real time. Wherein the battery capacity parameter of charging is a real time battery capacity parameter of both ends of the secondary battery during the charging process.

Accordingly, the step S220 comprises:
Step S221: when the charging voltage exceeds a total initial charging threshold, calculating a first ratio of a change of the charging voltage relative to a change of the battery capacity parameter of charging in real time, and when the first ratio is greater than a first threshold, determining that a charging characteristic point occurs during the charging process.
Step S230 comprises:
   Step S231: when the charging voltage is greater than or equal to a total charging cut-off voltage, acquiring a charging characteristic point number of the charging characteristic point, and if the charging characteristic point number is equal to N, determining that the uniformity of the secondary battery is good.

Referring to FIG. 1A, during the charging process of the step S211, the charging voltage U1 of both ends of the secondary battery 110 can be acquired in real time by the sampling circuit 140, and the charging voltage U1 is sent to the controller 130 in real time, the charging current is known or can be acquired by the controller 130, and the controller 130 calculates the current battery capacity of charging Q1 based on the charging current. For example, by integrating the charging current against time to acquire the battery capacity of charging Q1. In this way, a charging curve can be formed with the Q1 as the horizontal axis and the U1 as the vertical axis. Similarly, the current SOC can be acquired, thereby acquiring a curve with a similar pattern of change to that shown in FIG. 3.

In some embodiments, the sampling circuit 140 can also directly calculate the current battery capacity of charging Q1 based on the charging current, and then send the charging voltage U1 and battery capacity of charging Q1 together to the controller 130.

It should be noted that if a charging curve is acquired, the charging characteristic point is the inflection point on the charging curve. In other embodiments, there is no need to acquire the charging curve, and the charging characteristic point can be calculated directly by the step S221. The following illustration is based on the example that the charging curve is acquired, and is not intended to limit that the management method of the present disclosure must acquire the charging curve.

At step S221, firstly, setting one total initial charging threshold Uc0, and only when the U1 exceeds the Uc0, start calculating the first ratio R1 in real time, thereby recording a charging inflection point number of the charging curve. Combined with FIG. 3, since the initial voltage of the secondary battery is lower in the initial stage of charging, the charging speed is faster at this time, and then it reaches the slow charging stage, resulting in a lower risk of over-charging, therefore, there is no need to detect the risk of over-charging thereof during the stage. At the same time, due to the rapid increase in voltage, incorrect results may be acquired if determining at this time, therefore, by setting the total initial charging threshold Uc0 can also avoid the occurrence of false determination.

In some embodiments, the total initial charging threshold Uc0 is determined according to the characteristics of the battery cell and is N times of the voltage value reached when the slope of the charging curve of the battery cell first changes from fast to slow. For example, as shown in FIG. 3, assuming that the voltage value of the battery cell at the inflection point P1 is 3.3 V, then setting the total initial charging threshold Uc0=3.3 *N V. In practice, the total initial charging threshold may be a range, for example, floating back and forth by 20% with a center point of 3.3 *N V.

In some embodiments, the following equation (1) may be used to calculate the first ratio R1:

R1=dU1/dQ1 (1)

When R1>Th1 is satisfied, it is considered that one charging inflection point occurs on the charging curve at this time, and the Th1 denotes the first threshold.

The first threshold Th1 is set according to the performance of the battery cell used, and the present disclosure does not impose any specific limitations thereof. For example, the first threshold Th1 can be acquired through experiments.

A total charging cut-off voltage Ucc is also provided at the step S231. In some embodiments, the total charging cut-off voltage Ucc is equal to N times of the upper limit of charging voltage Ucmax of the battery cell. The upper limit of charging voltage Ucmax of the battery cell is the maximum voltage value to which the battery cell can be charged within a safe range. For example, setting Ucmax=3.6 V, then Ucc=3.6*N V. In other embodiments, the total charging cut-off voltage Ucc may not be equal to N*Ucmax, but rather within a certain range around N*Ucmax. That is, the total charging cut-off voltage Ucc may be greater or less than N times of the upper limit of charging voltage Ucmax of the battery cell.

For the battery cell, it may include a preset upper limit of charging voltage Ucmax, a dangerous high voltage Ux, a minimum discharging voltage Udmin, and a clamping voltage of shuttle agent Uclamp in a magnitude relationship of Udmin<Ucmax<Uclamp<Ux. Exemplarily, it is set that Udmin=2.5 V, Ucmax=3.6 V, Uclamp=3.65 V, and Ux=3.8 V. Wherein, different shuttle agent may have different clamping voltage of shuttle agents Uclamp, and the Uclamp may be set by adjusting the composition of the shuttle agent.

At step S231, when U1 ≥ Ucc and the charging characteristic point number is equal to N, determining that the uniformity of the secondary battery 110 is good, and at this time charging can be stopped.

In some embodiments, if in the step S231, when U1 ≥ Ucc and the charging inflection point number is less than N, then determining that the secondary battery 110 has poor uniformity and low balance, and therefore the balanced charging mode is triggered.

It is understandable that before the balanced charging mode is triggered, the secondary battery 110 may be controlled by the controller 130 to be charged by ordinary charging methods, including charging with the constant current, the size of the charging current depends on the charging and discharging capacity of the battery cell, and is usually much higher than the current in the balanced charging mode.

In some embodiments, the balanced charging mode comprises: charging with a constant voltage, the constant voltage is in a range between the total charging cut-off voltage Ucc and a total clamping voltage Uclamp 1, the total clamping voltage Uclamp1 being equal to N times of the clamping voltage of shuttle agent Uclamp of the battery cell. That is, Uclamp1= Uclamp*N. Based on the above example, the range of the constant voltage is: (3.6*N V, 3.65*N V). In the balanced charging mode, the electrons of the battery cell with high SOC enable the shuttle agent to be consumed, and there is no significant change in the charge of the battery cell with high SOC.

In some embodiments, the balanced charging mode comprises: charging with a constant current, the constant current being less than or equal to an allowable current of shuttle agent of the battery cell. The allowable current of shuttle agent is determined by the shuttle agent, and specifically, the constant current has a current value that is significantly less than the charging current in the normal charging mode.

The balanced charging mode enables some battery cells with low SOC to continue charging, while the charge of the battery cells with high SOC will not be increased, so as to make the SOC of each battery cell in the secondary battery 110 converge as a whole, which improves the uniformity and balance of the secondary battery 110, and prevent the occurrence of over-charging of the battery.

Continuing to record the charging characteristic point number in the balanced charging mode, and when the number reaches N, it means that the voltages of all the N battery cells have reached a certain value, and at this time, continuing to charge a first preset capacity Q11 to the secondary battery 110 and then stopping the charging process, thereby effectively preventing over-charging. It should be noted that the appearance of the inflection point does not indicate that the battery cell is fully charged, and the purpose of continuing to charge the Q11 is to make the battery cell get fully charged.

In some embodiments, the first preset capacity Q11 is equal to the increased battery capacity required to charge the voltage of the battery cell from the upper limit of charging voltage Ucmax to the clamping voltage of shuttle agent Uclamp of the battery cell. Since the upper limit of charging voltage Ucmax and the clamping voltage of shuttle agent Uclamp are known in advance, thus the first preset capacity Q11 is a constant.

In some cases, when the uniformity of the battery is particularly high, for example, when two battery cells have the inflection point at the same moment, the charging curve of the charging voltage U1 will overlap at the inflection points, so that the recorded charging inflection point number is less than the actual inflection point number. In this case, in step S221, the recorded charging inflection point number is less than N does not mean that the uniformity of the battery is poor. In order to distinguish this situation, the management method of the present disclosure further comprises: setting a first upper limit R1_up for the first ratio R1, when the first ratio R1 exceeds the first upper limit R1_up, determining that at least two mutually overlapping charging characteristic points occur during the charging process, and counting an actual number of the overlapping charging characteristic points into the charging characteristic point number. For example, when monitoring the first ratio R1 is to exceed the first upper limit R1_up,determining that there are greater than two mutually overlapping charging characteristic points. Further, when the first ratio R1 is in a first interval that exceeds the first upper limit R1 up, determining it has two overlapping points; when the first ratio R1 is in a second interval that exceeds the first upper limit R1_up, determining it has three overlapping points, and the value of the second interval being greater than the first interval; and so on, the number of overlapping points can be determined, and the actual number is counted as the charging characteristic point number.

The present disclosure does not limit the specific value of the first upper limit R1_up. Better first upper limit R1_up, first interval, second interval, and so on can be acquired through experiments to improve the sensitivity of detection of overlapping characteristic points.

By means of the above steps S211, S221, S231, the over-charging phenomenon during the charging process is effectively prevented.

In some embodiments, in the balanced charging mode, recording a time interval between adjacent charging inflection points, and acquiring a capacity difference of different battery cells according to the time interval. According to these embodiments, when the secondary battery enters the balanced charging mode, the occurrence moment of the newly detected charging inflection point can be recorded continuously, and within the time difference interval, the integral of the charging current over time is the capacity difference, so that the time interval between adjacent charging inflection points can reflect the capacity difference between the different battery cells, that is the uniformity difference, and the user can determine the uniformity of the battery after acquiring the capacity difference. The capacity difference information may be acquired by the controller 130 and be uploaded to a superior controller or user. For example, if a battery cell has a large capacity difference, the battery cell can be located then, and the battery cell can be removed or replaced in a subsequent process. In addition, the acquired capacity difference can make a validation of the uniformity of the battery as determined by the number of characteristic points.

FIG. 4 is a schematic diagram of a discharging curve of a battery cell in a secondary battery of an embodiment of the present disclosure. Similar to FIG. 3, the horizontal axis in FIG. 4 is the SOC in %, and the vertical axis is the voltage in V. Discharging process is the inverse process of the charging process. In FIG. 4, from the origin, the SOC gradually decreases from left to right along the horizontal axis, and the voltage gradually increases from bottom to top along the vertical axis. When the horizontal axis is the current battery capacity, the current battery capacity gradually decreases from left to right along the horizontal axis. When the horizontal axis is the battery discharging duration, the battery discharging duration gradually increases from left to right along the horizontal axis. As shown in FIG. 4, at the initial time, the voltage of the battery cell is high and lies between 3.4 V~3.5 V, and a discharging operation is required in some cases. The absolute value of the slope of the discharging curve also has the characteristics of being large on both sides and small in the middle. At the initial stage, the absolute value of the slope of the discharging curve is large, and the voltage drops to a voltage value at a fast speed, such as at the inflection point P3 in FIG. 4, after which the absolute value of the slope of the discharging curve becomes smaller, the speed of the voltage drop slows down, and until after reaching the inflection point P4, the absolute value of the slope of the discharging curve increases again, and the voltage drops rapidly. In FIG. 4, the inflection point P3 corresponds to a larger SOC, and the voltage is slightly larger than 3.3 V, the inflection point P4 corresponds to a smaller SOC, and the voltage is between 3.1-3.2V. FIG. 4 is used to represent the discharging pattern of the battery cell, and has a similar trend for the discharging curve of the entire secondary battery 110 shown in FIG. 1A. However, due to the existence of disuniformity in the SOC of each battery cell, the discharging curve of the entire secondary battery 110 does not correspond to a simple superposition of the discharging curves of the N battery cells, but is subject to fluctuations that results in a plurality of inflection points in the total discharging curve.

FIG. 4 is shown for illustrative purposes only and is not intended to limit the actual discharging curve and voltage values of the battery cell 120. Steps S210-S230 of embodiment 2 are described below with reference to FIG. 1A and FIG 4.

In the embodiment 2, in step S210, during the discharging process, acquiring the voltage and the battery capacity parameter of both ends of the secondary battery in real time.

In some embodiments, the step S210 comprises:
Step S212: acquiring a discharging voltage and a battery capacity parameter of discharging of both ends of the secondary battery in real time. Wherein the battery capacity parameter of discharging is a real time battery capacity parameter of both ends of the secondary battery during the discharging process.

Accordingly, the step S220 comprises:
Step S222: when the discharging voltage is less than a total initial discharging threshold, calculating a second ratio of a change of the discharging voltage relative to a change of the battery capacity parameter of discharging in real time, and when the second ratio is greater than a second threshold, determining that a discharging characteristic point occurs during the discharging process.
Step S230 comprises:
   Step S232: when the discharge of the secondary battery is finished, acquiring a discharging characteristic point number of the discharging characteristic point, and if the discharging characteristic point number is equal to N, determining that the uniformity of the secondary battery is good.

Combining FIG. 1A and FIG. 4, in the discharging process of step S212, the sampling circuit 140 shown in FIG. 1A can be used to acquire the discharging voltage U2 at both ends of the secondary battery 110 in real time, and send the discharging voltage U2 to the controller 130 in real time, the discharging current is known, and the controller 130 calculates the current battery capacity of discharging Q2 based on the discharging current. For example, by integrating the discharging current against the time to acquire the battery capacity of discharging Q2. In this way, a discharging curve with Q2 as the horizontal axis and U2 as the vertical axis can be formed. Similarly, the current SOC can be acquired, and a curve with a similar pattern of change to that shown in FIG. 4 can be acquired.

In some embodiments, the sampling circuit 140 can also directly calculate the current battery capacity of discharging Q2 based on the discharging current, and then send the discharging voltage U2 and the battery capacity of discharging Q2 together to the controller 130.

It should be noted that if a discharging curve is acquired, the discharging characteristic point is an inflection point on the discharging curve. In other embodiments, there is no need to acquire the discharging curve, and the discharging characteristic point can be calculated directly by the step S222. The following illustration is based on the example that a discharging curve is acquired, and is not intended to limit that the discharging curve must be acquired for the management method of the present disclosure.

In step S222, firstly, setting a total initial discharging threshold Ud0, when U2 is less than Ud0 and then starting to record the discharging inflection point number of the discharging curve. Referring to FIG. 4, since the risk of over-discharging is low in the initial stage of discharging, there is no need to detect the risk of over-discharging in the discharging stage before the inflection point P3. The set total initial discharging threshold Ud0 is the product of a value less than the voltage value at inflection point P3 multiplied by N. For example, setting Ud0=3.3*N V. Referring to FIG. 4, when the voltage of the battery cell is equal to 3.3 V, it starts to enter a stable discharging stage.

In some embodiments, the following equation (2) is used to calculate the second ratio R2:

R2=dU2/dQ2 (2)

When R2>Th2 is satisfied, it is considered that a discharging inflection point appears on the discharging curve at this time, and the Th2 denotes the second threshold. The present disclosure does not limit the specific value of the second threshold Th2, which can be acquired through experiments.

In step S232, it is possible to determine when to stop discharging based on the magnitude of the discharging voltage, even if the discharging of the secondary battery is finished.

In some embodiments, the total discharge cut-off voltage Udc is equal to N times of the minimum discharging voltage Udmin of the battery cell. When the discharging voltage of the battery cell reaches the lowest discharging voltage Udmin, it means that the battery cell has been discharged. Then, when the discharging voltage U2 of the secondary battery including the N battery cells is less than or equal to the total discharge cut-off voltage Udc, it is indicated that the secondary battery has been discharged and there is no need for further discharge, and then stopping discharging. At this time, if the detected discharging characteristic point number is equal to N, it means that the uniformity of the secondary battery is good.

In some embodiments, in order to prevent over-discharging, during the discharging process, before the discharging voltage of the secondary battery reaches the Udc, a determination is made for the discharging voltage U2, and when the discharging voltage U2 is less than the total discharge threshold Ud1, continuing to determine the discharging characteristic point, and when the discharging characteristic point number increases by 1, after continuing to release the second preset capacity Q21, the discharging process is stopped, wherein Udc< Ud1<Ud0. According to the embodiment, when the discharging voltage U2 is less than the total discharge threshold Ud1, it is indicated that most of the battery cells are entering the end of the discharging process, and then determining the inflection point in the discharging curve, when the presence of one inflection point is detected, it is indicated that there may be one battery cell that is about to reach the minimum discharging voltage, and at this time, after continuing to release the second preset capacity Q21, the discharging process is stopped, which can avoid over-discharging for the battery cell. At this time, although the discharging voltage U2 has not been reduced to the Udc, the discharge is not continued in order to avoid over-discharging of the battery cell. At this time, if the detected discharging characteristic point number is equal to N, it means that the uniformity of the secondary battery is good.

In some embodiments, the total discharge threshold Ud1 is the product of the voltage value close to the inflection point P4 multiplied by N. The voltage value close to the inflection point P4 indicates that it approaches from both sides of the voltage value respectively, that is a small range including the voltage value. For example, setting Ud1=3.2*N V. Referring to FIG. 4, when the voltage is equal to 3.2V, it is close to the inflection point P4, at which time the discharging process of one battery cell has come to an end.

In some embodiments, this second preset capacity Q21 is equal to the battery capacity that needs to be released to release the voltage of the battery cell from the voltage at the occurrence time of the inflection point to the minimum discharging voltage Udmin.

In some embodiments, the second preset capacity Q21 can be set as a constant in advance.

In some embodiments, the preferred Ud0, Ud1 can be determined experimentally to more sensitively respond to the relationship between the inflection point and the discharging state of the battery cell. It is to be noted that in practice, the values of Ud0, Ud1 may all float within a range without being limited to a single point.

In some embodiments, when the uniformity of the battery is particularly high, the discharging curves may overlap in inflection points, so that the recorded discharging inflection point number is smaller than the actual inflection point number. In response to this situation, in some embodiments, the management method of the present disclosure further comprises: setting a second upper limit R2_up for the second ratio R2, when the second ratio R2 exceeds the second upper limit R2_up, then determining that there are at least two mutually overlapping discharging characteristic points during the discharging process, and counting an actual number of the overlapping discharging characteristic points into the discharging characteristic point number. For example, when monitoring the second ratio R2 exceeds the second upper limit R2_up, determining that there are greater than two mutually overlapping discharging characteristic points. Further, when the second ratio R2 is in a third interval that exceeds the second upper limit R2_up, determining it has two overlapping points; when the second ratio R2 is in a fourth interval that exceeds the second upper limit R2_up, determining it has three overlapping points, and the value of the fourth interval being greater than the third interval; and so on, the number of overlapping points can be determined, and the actual number is counted as the discharging characteristic point number.

The present disclosure does not limit the specific value of the second upper limit R2_up. Better second upper limit R2_up, third interval, fourth interval, and so on can be acquired through experiments to improve the sensitivity of detection of overlapping characteristic points.

Recording the number of discharging inflection points during the discharging process, and when the discharging inflection point number is equal to N, it indicates that the uniformity of the secondary battery 110 is good, and when the discharging inflection point number is less than N and there are no overlapping inflection points, it indicates that the uniformity of the secondary battery 110 is poor. In these embodiments, the management method of the present disclosure further comprises: when the uniformity of the battery cell in the battery is poor, setting the charging mode of the next charging process to a balanced charging mode. According to these embodiments, the disuniformity of the battery can be detected during the discharging process, thereby prompting the user to directly adopt the balanced charging mode in the next charging process. In some embodiments, the secondary battery is set to have a certain upper limit of charging, and the upper limit of charging is less than the total charging cut-off voltage, which can result in the balanced charging mode not being triggered. Therefore, it is possible to automatically set the next charging process to adopt the forced balanced charging mode when poor uniformity is detected during the discharging process, which prevents over-charging and improves the disuniformity of the battery at the same time.

The management method of the present disclosure further comprises an embodiment 3, wherein in the step S210 of the embodiment 3, the voltage and battery capacity parameters of both ends of the secondary battery are acquired in real time in both the charging process and the discharging process, respectively. The charging process thereof may be referred to steps S211, S221, S231 of the embodiment 1, and the discharging process thereof may be referred to steps S212, S222, S232 of the embodiment 2, and all of the foregoing descriptions may be used to illustrate the embodiment 3, and will not be expanded upon.

It is to be noted that some parameters involved in the present management method, such as the total initial charging threshold Uc0, the first threshold Th1, the second threshold Th2, the total charging cut-off voltage Ucc, the upper limit of charging voltage Ucmax, the dangerous high voltage Ux, the minimum discharging voltage Udmin, the clamping voltage of shuttle agent Uclamp, the total initial discharging threshold Ud0, the total discharge cut-off voltage Udc, the total discharge threshold Ud1, the first preset capacity Q11, the second preset capacity Q21, and so on, the setting of the specific data of which may depend on other reference values, such as the battery temperature, the charging current, the discharging current, the battery aging degree, and so on, and thus parameter values can be established for different reference values, for example, adopting the method of table lookup to adjust the parameters in the management method of the present disclosure in real time, so as to improve the control accuracy.

Adopting the management method and the management system of the battery of the present disclosure, the uniformity of the battery is determined by characteristic point detection, and the charging process and the discharging process of the battery is controlled then, which can effectively prevent over-charging and over-discharging. At the same time, the number of sampling lines is reduced, the practicality is strong, and the need to use the expensive AFE chip is reduced or eliminated, and the cost of the product is reduced significantly.

The basic concepts have been described above, obviously, for those skilled in the art, the above disclosure is only as an example and does not constitute a limitation of the present disclosure. Although not expressly stated herein, those skilled in the art may make various modifications, improvements and amendments to the present disclosure. Such modifications, improvements, and amendments are suggested in the present disclosure, so such modifications, improvements, and amendments remain within the spirit and scope of the exemplary embodiments of the present disclosure.

Also, the present disclosure uses specific terms to describe embodiments of the present disclosure. For example, "one embodiment", "an embodiment", and/or "some embodiments" are meant to refer to a certain feature, structure, or characteristic associated with at least one embodiment of the present disclosure. Accordingly, it should be emphasized and noted that two or more references to "an embodiment" or "one embodiment" or "an alternative embodiment" in different places in this specification do not necessarily refer to the same embodiment. In addition, certain features, structures, or characteristics in one or more embodiments of the present disclosure may be suitably combined.

Similarly, it should be noted that in order to simplify the presentation of the disclosure of the present disclosure, and thus to assist in the understanding of one or more embodiments of the disclosure, the foregoing descriptions of the embodiments of the present disclosure sometimes group a plurality of features together in a single embodiment, accompanying drawings, or a description thereof. However, this method of disclosure does not imply that more features are required for the objects of the present disclosure than those mentioned in the claims. In fact, the features of the embodiments are less than all features of the single embodiments disclosed above.

Some embodiments use numbers to describe the number of components, attributes, and it should be understood that such numbers used in the description of the embodiments are modified in some examples by the modifiers "roughly", "approximately", or "generally". Unless otherwise stated, "roughly", "approximately", or "generally" indicates that a variation of ±20% is permitted in the described figures. Accordingly, in some embodiments, the numerical parameters used in the specification and in the claims are approximations, which can be changed depending on the desired characteristics of the individual embodiment. In some embodiments, the numerical parameters should be taken into account as a specified number of significant figures and use a general rounding method. Although the numerical fields and parameters used in some embodiments of the present disclosure to confirm the breadth of their ranges are approximations, in specific embodiments, such numerical are set as accurately as possible within the feasible range.

## Claims

1. A management method of a secondary battery, wherein the secondary battery comprises N battery cells connected in series, and N is a positive integer greater than or equal to 2, the method comprising:
acquiring a voltage and a battery capacity parameter of both ends of the secondary battery in real time during at least one process of a charging process and a discharging process;
determining a characteristic point of the voltage during its changing process, comprising: calculating a ratio of a change of the voltage relative to a change of the battery capacity parameter in real time when the voltage reaches a preset range, and determining that one characteristic point occurs during the changing process of the voltage when the ratio is greater than a characteristic threshold; and
determining uniformity of the secondary battery based on a number of the characteristic points.

2. The management method according to claim 1, wherein during the charging process, a step of acquiring the voltage and the battery capacity parameter of both ends of the secondary battery in real time comprises:
acquiring a charging voltage and a battery capacity parameter of charging of both ends of the secondary battery in real time;
a step of determining the characteristic point of the voltage during its changing process comprises: calculating a first ratio of a change of the charging voltage relative to a change of the battery capacity parameter of charging in real time when the charging voltage exceeds a total initial charging threshold, and determining that a charging characteristic point occurs during the charging process when the first ratio is greater than a first threshold;
a step of determining the uniformity of the secondary battery based on the number of the characteristic points comprises:
acquiring a charging characteristic point number of the charging characteristic point when the charging voltage is greater than or equal to a total charging cut-off voltage, and determining that the uniformity of the secondary battery is good if the charging characteristic point number is equal to N.

3. The management method according to claim 2, wherein the total charging cut-off voltage is equal to N times of an upper limit of charging voltage of the battery cell.

4. The management method according to claim 2, further comprising: setting a first upper limit for the first ratio, and determining that at least two mutually overlapping charging characteristic points occur during the charging process when the first ratio exceeds the first upper limit, counting an actual number of the overlapping charging characteristic points into the charging characteristic point number.

5. The management method according to claim 2, wherein the step of determining the uniformity of the secondary battery based on the number of the characteristic points further comprises: determining that the uniformity of the secondary battery is poor if the charging characteristic point number is less than N; setting a charging mode to a balanced charging mode when determining that the uniformity of the secondary battery is poor, and in the balanced charging mode, continuing to charge a first preset capacity and then stopping the charging process when the charging characteristic point number is equal to N.

6. The management method according to claim 5, wherein the balanced charging mode comprises: charging with a constant voltage, the constant voltage being in a range between the total charging cut-off voltage and a total clamping voltage, the total clamping voltage being equal to N times of a clamping voltage of shuttle agent of the battery cell.

7. The management method according to claim 5, wherein the balanced charging mode comprises: charging with a constant current, the constant current being less than or equal to an allowable current of shuttle agent of the battery cell.

8. The management method according to claim 5, wherein the first preset capacity is equal to the increased battery capacity required to charge the voltage of the battery cell from the upper limit of charging voltage of the battery cell to the clamping voltage of shuttle agent of the battery cell.

9. The management method according to claim 5, wherein the balanced charging mode comprises: recording a time interval between adjacent charging characteristic points, and acquiring a capacity difference of different battery cells according to the time interval.

10. The management method according to claim 1, wherein during the discharging process, a step of acquiring the voltage and the battery capacity parameter of both ends of the secondary battery in real time comprises:
acquiring a discharging voltage and a battery capacity parameter of discharging of both ends of the secondary battery in real time;
a step of determining the characteristic point of the voltage during the changing process comprises: calculating a second ratio of a change of the discharging voltage relative to a change of the battery capacity parameter of discharging in real time when the discharging voltage is less than a total initial discharging threshold, and determining that a discharging characteristic point occurs during the discharging process when the second ratio is greater than a second threshold;
a step of determining the uniformity of the secondary battery based on the number of the characteristic points comprises:
acquiring a discharging characteristic point number of the discharging characteristic point when the discharge of the secondary battery is finished, and determining that the uniformity of the secondary battery is good if the discharging characteristic point number is equal to N.

11. The management method according to claim 10, wherein when the discharging voltage is less than or equal to a total discharge cut-off voltage, the discharge of the secondary battery is finished.

12. The management method according to claim 10, further comprising: before the discharging voltage reaches the total discharge cut-off voltage, and when the discharging voltage is less than a total discharge threshold, and when the discharging characteristic point number increases by 1, and after continuing to release a second preset capacity, the discharge of the secondary battery is finished, wherein the total discharge threshold is less than the total initial discharging threshold, and the total discharge threshold is greater than the total discharge cut-off voltage.

13. The management method according to claim 10, further comprising: setting a second upper limit for the second ratio, and determining that at least two mutually overlapping discharging characteristic points occur during the discharging process when the second ratio exceeds the second upper limit, counting an actual number of the overlapping discharging characteristic points into the discharging characteristic point number.

14. The management method according to claim 10, wherein the step of determining the uniformity of the secondary battery based on the number of the characteristic points further comprises: determining that the uniformity of the secondary battery is poor if the discharging characteristic point number is less than N; setting a charging mode for a next charging process to a balanced charging mode when determining that the uniformity of the secondary battery is poor.

15. A management system of a secondary battery, the secondary battery comprising N battery cells connected in series, N being a positive integer greater than or equal to 2, wherein it comprises a controller and at least one sampling circuit, the at least one sampling circuit being connected to both ends of the secondary battery for capturing a voltage of the secondary battery and sending the voltage to the controller, the controller being configured to: perform the management method according to any one of claims 1 to 14.
